# FASCICULE DE BREVET EUROPEEN

(11) **EP 2 174 772 B1**
(45) Date de publication et mention de la délivrance du brevet: **16.05.2012**
(21) Numéro de dépôt: 09305801.4
(22) Date de dépôt: 31.08.2009
(51) Int. Cl.: B29C 59/02, B29B 13/02, B29B 13/08, H01L 21/311, H01L 51/00, H01M 8/10

(54) **Structuration en surface de couches minces par éjection localisée de liquide immiscible**
Oberflächenstrukturierung von Dünnschichten durch lokalisierten Ausstoß von unvermischbarer Flüssigkeit
Structuring on the surface of thin layers by localised ejection of non-miscible liquid

(30) Priorité: 10.10.2008 FR 0856890
(43) Date de publication de la demande: 14.04.2010
(73) Titulaire: Commissariat à l'Énergie Atomique et aux Énergies Alternatives, 75015 Paris (FR)
(72) Inventeur: Serbutoviez, Christophe, 38500 Voiron (FR); Latour, Antoine, 38000 Grenoble (FR); Sonier, Flore, 38410 Vaulnaveys le Bas (FR)
(74) Mandataire: Vuillermoz, Bruno

(56) Documents cités:
- US-A1- 2003 029 831
- US-A1- 2006 286 726

## Description

### DOMAINE DE L'INVENTION

La présente invention a trait à la structuration, c'est-à-dire à la réalisation de topologies, à la surface de couches minces liquides ou gélifiées selon la revendication 1. Elle consiste à éjecter, à l'aide de têtes de micro dispense, des gouttes d'un matériau immiscible avec le matériau constitutif de la couche mince.

De par l'utilisation de tête de micro dispense, il est possible de modifier à souhait le nombre, la position, la répartition et la forme de la topologie ainsi obtenue. De telles topologies permettent notamment de démultiplier la surface en contact entre deux matériaux ou de modifier localement des propriétés optiques d'une couche mince.

### ETAT ANTERIEUR DE LA TECHNIQUE

La structuration de matériaux polymères peut se faire à l'aide des méthodes classiques de la microélectronique, c'est-à-dire par des étapes de photolithographie. Cependant, ces méthodes demeurent coûteuses et leur compatibilité avec les matériaux organiques, comme notamment les matériaux polymères, reste limitée.

Par ailleurs, la technique dite du *«Hot Embossing*» permet de créer une topologie de surface sur un matériau. Toutefois, cette technique ne peut être mise en oeuvre que sur des matériaux résistants à la fois à la température et la pression qui sont inhérentes à ce procédé.

A noter que pour ces deux méthodes, tout changement de motif requiert un changement de moule ou de masque. Il n'est donc pas possible de modifier les motifs de manière aisée et à faible coût.

La publication de Kawase et al. (Adv. Mater. 13(21), 1601-05, 2001) décrit également une méthode qui trouve une application dans l'électronique organique. Elle consiste à dissoudre un polymère à l'aide d'un solvant dudit polymère. Ce solvant est éjecté par une tête ou buse jet d'encre et dissout effectivement le polymère. Cependant, il apparaît autour des motifs un redépôt de matière qui est préjudiciable à la qualité des topologies ainsi fabriquées.

Enfin, une dernière méthode recensée est celle décrite dans la publication de Sirringhaus et al. (Science 290(5499), 2123-26, 2000). Le substrat est recouvert de zones hydrophiles ou hydrophobes, obtenues à partir de couches minces. Suivant la nature de l'encre, celle-ci se localise préférentiellement sur les zones hydrophiles ou hydrophobes. Cette méthode fait donc appel à un dépôt d'une couche mince de matière hydrophile ou hydrophobe sur le substrat, suivi d'un « *patterning* » réalisé par des techniques de photolithographie. Le coût d'un tel procédé est élevé et la structuration de la couche se fait obligatoirement sur toute son épaisseur.

Le document US2003/029831 décrit un procédé pour la réalisation de topologies à la surface d'une couche organique se présentant sous forme liquide ou gélifiée, et comprenant une étape de projection localisée d'au moins un matériau liquide.

### EXPOSE DE L'INVENTION

Il existe donc un besoin évident de développer des méthodes aisées et peu coûteuses permettant de créer, de manière contrôlée, des motifs à la surface de couches minces de nature très diverse.

Ainsi, l'invention concerne un procédé de réalisation de topologies à la surface d'une couche mince organique se présentant sous forme liquide ou gélifiée, comprenant une étape de projection localisée d'un matériau liquide non miscible avec le matériau constituant la couche mince.

Le procédé selon l'invention repose sur le principe physique de la séparation de phases aussi appelée démixtion. L'incompatibilité de mélange entre le matériau liquide éjecté, appelé par la suite phase II, et le matériau constitutif de la couche mince, appelée par la suite phase I, se traduit par l'immiscibilité du liquide dans ce matériau. En raison des forces physiques associées à la séparation de phases, cette seconde phase (II) repousse le matériau constitutif de la phase I. Ainsi, la couche mince constituée par le matériau de la phase I se déforme. A noter que le matériau de la phase II n'est pas un solvant du matériau de la phase I.

La présente invention se concentre sur la structuration en surface des couches minces. Ceci implique que la déformation qui creuse la couche mince ne la traverse pas. En d'autres termes et dans un mode de réalisation privilégié selon lequel la couche mince repose sur un substrat, la couche mince possède toujours la même surface de contact avec le substrat à l'issue du procédé selon l'invention.

Comme déjà dit, la couche mince visée est de nature organique. En pratique, le matériau de la phase I, à savoir constitutif de la couche mince, se trouve sous forme liquide ou avantageusement gélifiée. Plus précisément, un tel matériau se présente sous l'une des formes suivantes : monomères en solution, polymères en solution, monomères liquides ou gel de polymères.

Une couche mince visée par l'invention présente avantageusement une épaisseur supérieure ou égale à 20 micromètres. Cette épaisseur correspond à celle mesurée sur la couche dans son état liquide ou gélifié, c'est-à-dire au moment de la projection du matériau non miscible. Cette épaisseur peut ensuite diminuer notamment par séchage ou polymérisation.

Comme mentionné plus haut, les topologies créées à l'aide du procédé selon l'invention sont localisées en surface de la couche. Plus précisément, leur profondeur ne dépasse pas 50 % de l'épaisseur de la couche, et de manière préférentielle reste inférieure à 20%.

Dans le cas où le matériau 1 constituant la couche mince est sous forme liquide, il présente avantageusement une viscosité comprise entre 200 et 5000 cps. Ces valeurs de viscosité sont déterminées par la technique Brookfield bien connue de l'homme du métier (T ambiante, P = 1 atm). Une étape préalable de recuit peut être nécessaire pour atteindre ces valeurs.

Alternativement et pour éviter la coalescence du matériau projeté, il peut être souhaitable de gélifier le matériau constitutif de la couche mince avant de procéder à la projection du matériau non miscible. Cette gélification est avantageusement effectuée par photo- ou thermopolymérisation. A cet effet, un initiateur de polymérisation peut être ajouté au matériau.

Concernant le matériau mis en oeuvre pour créer les topologies à la surface de la couche mince, il présente la propriété essentielle d'être non miscible avec le matériau de la couche mince. En d'autres termes, il présente une incompatibilité de mélange avec le matériau constitutif de la couche mince.

Dans la mesure où la projection localisée de ce matériau se fait avantageusement à l'aide d'une tête de microdispense, encore plus avantageusement d'une tête d'impression jet d'encre, celui-ci est, de manière préférée, un liquide éjecté de la tête sous forme de gouttes. Ainsi, la projection du matériau immiscible à la surface de la couche mince, avantageusement sous forme de gouttes, entraîne la formation d'alvéoles.

En outre, et lorsque ce liquide est moins dense que le matériau constitutif de la couche mince, il a été observé que les topologies étaient réalisées uniquement en surface. Ceci constitue donc un mode de réalisation privilégiée dans la mesure où une telle structuration est recherchée. Il est toutefois possible de répéter la projection au même endroit pour « creuser » le motif.

En déplaçant la couche et/ou le dispositif de projection, il est possible de créer de telles topologies à différents endroits de la couche mince.

La structure et la fréquence des alvéoles créées à la surface de la couche mince peuvent donc être choisies et contrôlées. Ainsi, notamment en fonction du pas d'éjection des gouttes et de la viscosité du matériau constitutif de la phase 1 ou de son taux de réticulation, il est possible de juxtaposer les zones de déformation et de réaliser des topologies variées.

Le liquide non miscible de la phase II, présent dans les alvéoles après projection, a deux devenirs possibles qui dépendent notamment de sa valeur de tension de vapeur dans les conditions ambiantes (température et pression ordinaires) :
S'il possède une forte valeur de tension de vapeur (généralement supérieure ou égale à 1mm de mercure à Patm et Tambiante), il peut être évaporé, notamment au cours d'une étape de recuit. Simultanément, des solvants éventuellement présents dans le matériau constitutif de la couche mince sont également évaporés ou celui-ci subit une polymérisation.

Alternativement et notamment s'il possède une faible valeur de tension de vapeur (généralement inférieure ou égale à 1mm de mercure à Patm et Tambiante) et s'il est polymérisable, le matériau non miscible peut être soumis à une polymérisation, avantageusement une photopolymérisation ou une thermopolymérisation en présence d'un initiateur adapté. Si le matériau constitutif de la phase I est également thermo- ou photopolymérisable, il peut subir une polymérisation simultanée. Ceci aboutit alors à une structure associant intimement deux matériaux. Ainsi, à l'aide d'un procédé simple, il est possible de créer des reliefs et d'assurer leur remplissage partiel ou total à l'aide d'un matériau d'intérêt.

De telles structures permettent une augmentation de la surface de contact entre couches. Elle peut, par exemple, être mise à profit pour la réalisation de pile à combustible et ainsi de structurer une couche de polymère électrolytique comme le Nafion^{®} (marque déposée de Dupont de Nemours). Une telle topologie permet de démultiplier la surface en contact entre l'électrolyte polymère et une couche catalytique à base de carbone platiné. Il s'en suit un accroissement de la puissance électrique de la pile à combustible.

En outre, lorsque les indices optiques réels ou imaginaires des matériaux constitutifs des phases I et II sont différents, il est possible de modifier les caractéristiques physiques de la lumière transmise ou réfléchie par un tel dispositif.

### EXEMPLE DE REALISATION DE L'INVENTION

La manière dont l'invention peut être réalisée et les avantages qui en découlent, ressortiront mieux des exemples de réalisation qui suivent, donnés à titre indicatif et non limitatif, à l'appui des figures annexées.
La figure 1 représente schématiquement une vue en section (A) et de dessus (B) d'une couche mince présentant à sa surface des alvéoles résultant du procédé selon l'invention.
La figure 2 représente une vue de dessus (A) et de biais (B) d'une structuration en surface d'une couche mince se présentant sous la forme de créneaux identiques, espacés régulièrement.
La figure 3 représente une vue en section d'une pile à combustible intégrant un substrat sur lequel sont déposés successivement une anode, une couche de polymère électrolyte structuré selon l'invention, et une cathode.
La figure 4 représente schématiquement une vue schématique en section d'une structure obtenue à l'aide d'un procédé selon l'invention dans le cas où les matériaux I et II sont polymérisables.

### Exemple 1 :

Une expérience a été réalisée avec une solution comprenant les monomères et l'initiateur suivants, dont le pourcentage en masse est indiqué :
- 2,2,3,3,4,4,4-Heptafluorobutyle acrylate (monomère) : 95% ;
- 1,1,2,2,3,3 hexafluoro 1,3 butanediol diacrylate (monomère) : 4% ;
- Irgacure 651^{®} (CIBA) (initiateur radicalaire) : 1 %

Ils constituent le matériau de la phase I (**1**).

La densité de ce mélange est de 1,6 par rapport au mélange de monomères et de l'initiateur suivants, constituant le matériau de la phase II (**2**) et dont le pourcentage en masse est indiqué :
- ethylhexyl acrylate (monomère) : 90% ;
- nonylacrylate (monomère) : 5% ;
- ethyleneglycol dimethacrylate (monomère) : 4% ;
- Irgacure 651^{®} (CIBA) (initiateur radicalaire) : 1 %.

Le matériau constitutif de la phase I (**1**) est déposé par enduction sur un substrat souple de type polyéthylène naphtalate (Teonex^{®} Q65 Dupont Teijin film) (**3**). La couche (**1**) est gélifiée par une insolation en lumière ultraviolet à 365 nanomètres pendant 5 secondes à une énergie de 7 mW/cm². L'épaisseur de la couche est de 400 micromètres

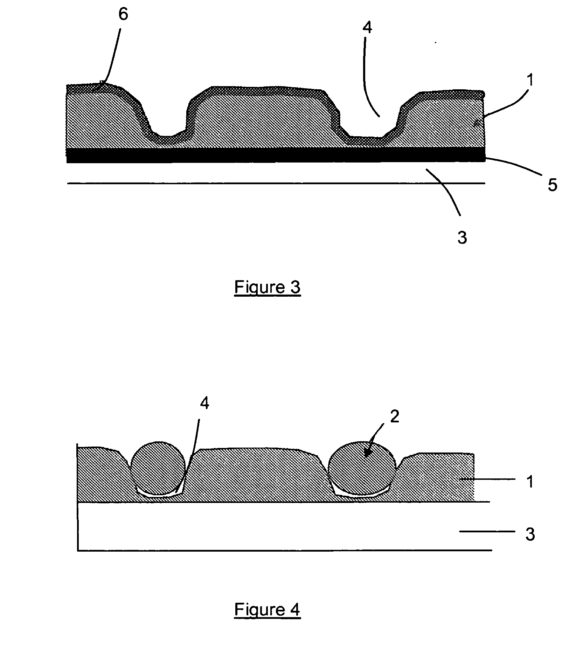

Le substrat (**3**) est ensuite amené à la machine jet d'encre Altadrop (ALTATECH). L'imprimante est équipée d'une tête Microfab de 60 micromètres. 20 gouttes du matériau constitutif de la phase II (**2**) sont éjectées par localisation. Après photopolymérisation sous lumière UV à 365 nanomètres pendant 200 secondes à une énergie de 7 mW/cm², on observe une structure qui présente une juxtaposition de domaines de polymères issus du matériau de la phase II (**2**) dans une matrice de polymères issus du matériau de la phase I (**1**), selon la figure 4.

### Exemple 2 :

Une expérience a été réalisée avec une solution de fluoropolymère Cytop^{®} à 9% (Asahi Glass).

La densité de ce produit (**1**) est de 1,9 par rapport au cristal liquide nématique 4'-Pentyl-4-biphenylcarbonitrile (**2**).

Le matériau Cytop^{®} est déposé par enduction sur un substrat souple (**3**) de type polyéthylène naphtalate (Teonex^{®} Q65 Dupont Teijin film). L'épaisseur du dépôt avant recuit est de 300 micromètres. L'échantillon est recuit pendant 20 secondes à 40°C. La viscosité de la solution de Cytop^{®} est alors de 400 centipoises.

La couche (**1**) ainsi obtenue est amenée sous une imprimante jet d'encre dimatix DMP 2818. 20 gouttes de cristal liquide 4'-Pentyl-4-biphenylcarbonitrile (**2**) sont éjectées par localisation. L'ensemble ainsi obtenu est recuit à 100°C pendant 120 secondes. On observe une structure qui présente une juxtaposition de domaines de cristal liquide (**2**), indépendants les uns des autres, dans une matrice de fluoropolymère (**1**), selon le schéma de la figure **4**.

### Exemple 3 :

Une expérience a été réalisée avec une solution de polymère Cytop^{®} à 9% (Asahi Glass).

La densité de ce produit (**1**) est de 1,8 par rapport à un mélange (**2**) des monomères et de l'initiateur suivants, dont le pourcentage en masse est indiqué :
- ethylhexyl acrylate (monomère) : 85% ;
- nonylacrylate (monomère) : 10% ;
- éthylène glycol diméthacrylate (monomère) : 4% ;
- Irgacure 651^{®} (CIBA) (initiateur radicalaire) : 1 %.

La solution de Cytop^{®} est deposée par enduction sur un substrat souple (**3**) de type polyéthylène naphtalate (Teonex^{®} Q65 Dupont Teijin film). L'épaisseur du dépôt avant recuit est de 300 micromètres. L'échantillon est recuit pendant 20 secondes à 40°C. La viscosité de la solution de Cytop^{®} est alors de 400 centipoises.

La couche ainsi obtenue (**1**) est amenée sous une imprimante jet d'encre dimatix DMP 2818. L'imprimante est équipée d'une tête de 10 picolitres commercialisée par Dimatix. 20 gouttes du mélange décrit ci-dessus (**2**) sont éjectées par localisation. L'ensemble ainsi obtenu est recuit à 100°C pendant 120 secondes puis il est photopolymerisé sous lumière UV à 365 nanomètres pendant 200 secondes à une énergie de 7 mW/cm². La structure obtenue est telle qu'illustrée à la figure 4.

### Exemple 4 :

Une expérience a été réalisée sur une dispersion de Nafion 2010^{®} (Dupont).

La densité de la dispersion (**1**) est de 1,2 par rapport au toluène (**2**).

Cette dispersion est déposée par enduction sur un wafer de silicium (**3**). L'épaisseur du dépôt avant recuit est de 400 micromètres. Le substrat est recuit pendant 30 secondes à 50°C. La viscosité de la dispersion de Nafion^{®} après recuit est de 500 centipoises.

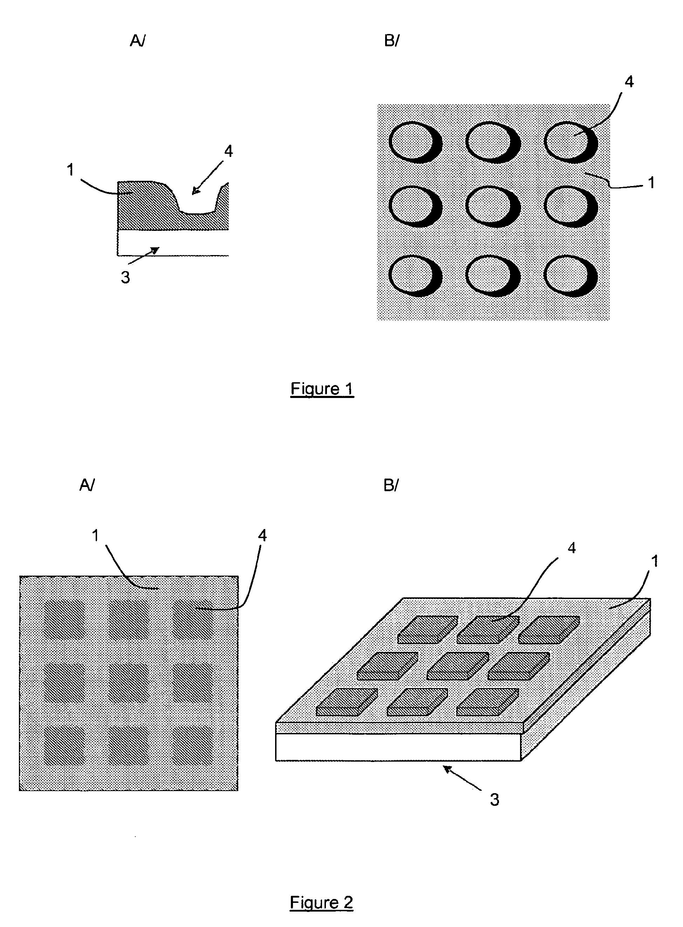

Le substrat (**3, 1**) est amené sous une imprimante jet d'encre dimatix DMP 2818. 15 gouttes de toluène (**2**) sont été éjectées par localisation selon un pas en X et en Y égal à 500 micromètres. Après recuit de la couche à 85°C pendant 1 heure, on observe une structuration de la couche de Nafion^{®} sous forme de créneaux tels que ceux présentés aux figures 1 et 2.

Le procédé selon l'invention peut être mis à profit pour la réalisation de pile à combustible, en particulier pour la structuration de la couche de polymère électrolytique (**1**), par exemple constituée de Nafion^{®} (marque déposée de Dupont de Nemours). Une telle topologie, illustrée à la figure 3, permet de démultiplier la surface en contact entre l'électrolyte polymère et une couche catalytique à base de carbone platiné (**6**). Il s'en suit un accroissement de la puissance électrique de la pile à combustible.

## Revendications

1. Procédé de réalisation de topologies (4) à la surface d'une couche mince organique (1) se présentant sous forme liquide ou gélifiée et reposant sur un substrat (3), comprenant une étape de projection localisée d'au moins un matériau liquide (2) non miscible avec le matériau constituant la couche mince (1).

2. Procédé de réalisation de topologies à la surface d'une couche mince organique selon la revendication 1, ***caractérisé* en ce que** le matériau constituant la couche mince (1) se présente avantageusement sous la forme suivante: monomères en solution, polymères en solution, monomères liquides ou gel de polymères.

3. Procédé de réalisation de topologies à la surface d'une couche mince organique selon l'une des revendications précédentes, ***caractérisé* en ce que** la couche mince (1) présente une épaisseur supérieure ou égale à 20 micromètres dans son état liquide ou gélifié.

4. Procédé de réalisation de topologies à la surface d'une couche mince organique selon l'une des revendications 1 à 3, ***caractérisé* en ce que** le matériau constituant la couche mince se trouve sous forme liquide, avec une viscosité comprise entre 200 et 5000 cps.

5. Procédé de réalisation de topologies à la surface d'une couche mince organique selon l'une des revendications 1 à 4, ***caractérisé* en ce que** le matériau constituant la couche mince se trouve sous forme liquide et subit une gélification, avantageusement par photopolymérisation ou thermopolymérisation, avant l'étape de projection.

6. Procédé de réalisation de topologies à la surface d'une couche mince organique selon l'une des revendications précédentes, ***caractérisé* en ce que** le matériau liquide non miscible (2) est moins dense que le matériau constituant la couche mince (1).

7. Procédé de réalisation de topologies à la surface d'une couche mince organique selon l'une des revendications précédentes, ***caractérisé* en ce que** la projection localisée est réalisée à l'aide d'une tête de microdispense, avantageusement une tête d'impression jet d'encre.

8. Procédé de réalisation de topologies à la surface d'une couche mince organique selon l'une des revendications précédentes, ***caractérisé* en ce qu'**après l'étape de projection, le matériau constituant la couche mince (1) et/ou le matériau liquide non miscible (2) sont soumis à une étape d'évaporation.

9. Procédé de réalisation de topologies à la surface d'une couche mince organique selon l'une des revendications précédentes, ***caractérisé* en ce qu'**après l'étape de projection, le matériau constituant la couche mince (1) et/ou le matériau non miscible (2) sont soumis à une étape de polymérisation.

## Claims

1. A method for producing topologies (4) on the surface of an organic thin film (1) having a liquid or gelated form and resting on a substrate (3), comprising a step of localized spraying of at least one liquid material (2) that is immiscible with the material constituting the thin film (1).

2. The method for producing topologies on the surface of an organic thin film as claimed in claim 1, ***characterized* in that** the material constituting the thin film (1) is advantageously in the following form: monomers in solution, polymers in solution, liquid monomers or gel of polymers.

3. The method for producing topologies on the surface of an organic thin film as claimed in either of the preceding claims, ***characterized* in that** the thin film (1) has a thickness of 20 microns or more in its liquid or gelated state.

4. The method for producing topologies on the surface of an organic thin film as claimed in one of claims 1 to 3, ***characterized* in that** the material constituting the thin film is in liquid form, with a viscosity between 200 and 5000 cps.

5. The method for producing topologies on the surface of an organic thin film as claimed in one of claims 1 to 4, ***characterized* in that** the material constituting the thin film is in liquid form and undergoes a gelation, advantageously by photopolymerization or thermopolymerization, before the spraying step.

6. The method for producing topologies on the surface of an organic thin film as claimed in either of the preceding claims, ***characterized* in that** the immiscible liquid material (2) has a lower density than the material constituting the thin film (1).

7. The method for producing topologies on the surface of an organic thin film as claimed in either of the preceding claims, ***characterized* in that** the localized spraying is carried out using a microdispensing printhead, advantageously an inkjet printhead.

8. The method for producing topologies on the surface of an organic thin film as claimed in either of the preceding claims, ***characterized* in that** after the spraying step, the material constituting the thin film (1) and/or the immiscible liquid material (2) are subjected to an evaporation step.

9. The method for producing topologies on the surface of an organic thin film as claimed in either of the preceding claims, ***characterized* in that** after the spraying step, the materials constituting the thin film (1) and/or the immiscible material (2) are subjected to a polymerization step.

## Patentansprüche

1. Verfahren zum Herstellen von Topologien (4) auf der Oberfläche einer organischen Dünnschicht (1), die sich in einer flüssigen oder in einen Gelzustand versetzten Form darstellt und auf einem Substrat (3) liegt, einen Schritt des lokalisierten Aufspritzens mindestens eines flüssigen Materials (2) umfassend, das nicht mit dem die Dünnschicht (1) bildenden Material mischbar ist.

2. Verfahren nach Anspruch 1, zum Herstellen von Topologien auf der Oberfläche einer organischen Dünnschicht, **dadurch gekennzeichnet, dass** das die Dünnschicht (1) bildende Material sich vorteilhafter Weise in der folgenden Form darstellt: Monomere in Lösung, Polymere in Lösung, Flüssigmonomere oder Gel aus Polymeren.

3. Verfahren nach einem der vorhergehenden Ansprüche, zum Herstellen von Topologien auf der Oberfläche einer organischen Dünnschicht, **dadurch gekennzeichnet, dass** die Dünnschicht (1) in ihrem flüssigen oder in Gelzustand versetzten Zustand eine Dicke von mehr als oder gleich 20 Mikrometer aufweist.

4. Verfahren nach einem der Ansprüche 1 bis 3, zum Herstellen von Topologien auf der Oberfläche einer organischen Dünnschicht, **dadurch gekennzeichnet, dass** sich das die Dünnschicht bildende Material in flüssiger Form mit einer Viskosität zwischen 200 und 5000 cps befindet.

5. Verfahren nach einem der Ansprüche 1 bis 4, zum Herstellen von Topologien auf der Oberfläche einer organischen Dünnschicht, **dadurch gekennzeichnet, dass** sich das die Dünnschicht bildende Material in flüssiger Form befindet und vor dem Aufspritzschritt eine Gelierung vorteilhafter Weise durch Photopolymerisierung oder Thermopolymerisierung erfährt.

6. Verfahren nach einem der vorhergehenden Ansprüche, zum Herstellen von Topologien auf der Oberfläche einer organischen Dünnschicht, **dadurch gekennzeichnet, dass** das flüssige, nicht mischbare Material (2) weniger dicht ist als das die Dünnschicht (1) bildende Material.

7. Verfahren nach einem der vorhergehenden Ansprüche, zum Herstellen von Topologien auf der Oberfläche einer organischen Dünnschicht, **dadurch gekennzeichnet, dass** das lokalisierte Aufspritzen mittels eines Mikrospenderkopfs, vorteilhafter Weise mittels eines Tintenstrahldruckkopfs erfolgt.

8. Verfahren nach einem der vorhergehenden Ansprüche, zum Herstellen von Topologien auf der Oberfläche einer organischen Dünnschicht, **dadurch gekennzeichnet, dass** nach dem Aufspritzschritt das die Dünnschicht (1) bildende Material und/oder das flüssige, nicht mischbare Material (2) einem Verdampfungsschritt unterzogen werden/wird.

9. Verfahren nach einem der vorhergehenden Ansprüche, zum Herstellen von Topologien auf der Oberfläche einer organischen Dünnschicht, **dadurch gekennzeichnet, dass** nach dem Aufspritzschritt das die Dünnschicht (1) bildende Material und/oder das flüssige, nicht mischbare Material (2) einem Polymerisierungsschritt unterzogen werden/wird.
